# EUROPEAN PATENT APPLICATION

(11) **EP 3 024 138 A1**
(43) Date of publication of application: **25.05.2016**
(21) Application number: 14825793.4
(22) Date of filing: 16.07.2014
(51) Int. Cl.: H03D 7/16

(54) **PHASE SHIFTER AND TRANSMISSION SYSTEM EQUIPPED WITH SAME**

(30) Priority: 16.07.2013 KR 20130083611
(71) Applicant: LG Innotek Co., Ltd., Seoul 100-714 (KR)
(72) Inventor: PARK, Young Hun, Seoul 100-714 (KR)
(74) Representative: DREISS Patentanwälte PartG mbB
(86) International application number: PCT/KR2014/006442
(87) International publication number: WO 2015/009056

(57) **Abstract**

Disclosed are a phase shifter and a transmission system equipped with same. A phase shifter according to an embodiment of the present invention has a section having an open circular shape, thereby shifting the phases of signals entering from the input unit.

## Description

### TECHNICAL FIELD

The present disclosure relates to a phase shifter and a transmission system equipped with same.

### BACKGROUND ART

In general, isolation between antennas requires improvement for increase in wireless transmission data speed (through-put) in a system transmitting and receiving data through frequencies of a plurality of bandwidths.

A wireless (radio) transmission/receiving system uses a structure applied with an external antenna only, a structure applied with internal and external a ntennas and a structure applied with an internal antenna only. The structure ap plied with an external antenna only and the structure applied with internal and external antennas have no great problems of isolation between antennas, but va rious researches are being waged for improving isolation between antennas in t he structure applied with an internal antenna only.

However, various problems arise as the number of antennas increases to increase a common ground for antennas, and to increase near field electromagn etic system coupling.

### DETAILED DESCRIPTION OF THE INVENTION

### TECHNICAL SUBJECT

The technical subject to be solved by the present invention is to provide a phase shifter configured to minimize interference between first and second signals and to increase data transmission amount by shifting phases of the first and second signals to have a predetermined phase difference, and a system for transmitting (hereinafter referred to as "transmission system") using the same.

### TECHNICAL SOLUTION

To achieve these and other advantages and in accordance with the purpose of the present invention, in one general aspect of the present invention, there may be provided a phase shifter comprising: an input unit through which a signal is inputted; a phase shifter having a partially-opened round shape and configured to shift a phase of the signal; and an output unit configured to output a phase-shifted signal by the phase shifter.

In some exemplary embodiment of the present invention, the phase shifter may further comprise a first connector connected to a portion of a partially-opened part of the phase shifter and configured to connect the input unit and the phase shifter; and a second connector connected to the other portion of the partially-opened part of the phase shifter and configured to connect the output unit and the phase shifter.

In some exemplary embodiment of the present invention, the phase shifted by the phase shifter may be determined by size of a diameter of the phase shifter.

In another general aspect of the present invention, there may be provided a transmission system using a phase shifter, the system comprising: a first transmission unit configured to transmit a first signal through at least one first antenna; and a second transmission unit configured to transmit a second signal through at least one second antenna, wherein the second transmission unit includes a phase shifter configured to shift the second signal to have a phase difference from the first signal.

In some exemplary embodiment of the present invention, the number of the phase shifter may correspond to that of the at least second antenna.

In some exemplary embodiment of the present invention, the phase shifter may have one of Ω, 8, and ∝ shapes.

In some exemplary embodiment of the present invention, a frequency band of the first signal may correspond to that of the second signal.

In some exemplary embodiment of the present invention, a frequency band of the first signal may be different from that of the second signal.

### ADVANTAGEOUS EFFECT

Exemplary embodiments of the present invention have an advantageous effect in that data transmission speed can be improved by minimizing interference between two signals through orthogonal phase positioning of same frequency banded-signals.

Another advantageous effect is that transmission speed of a wireless (radio) system using a plurality of antennas can be improved.

Still another advantageous effect is that data transmission speed can be improved by minimizing interference between signals through shifting of orthogonal or different positioning of phases of a plurality of signals.

### BRIEF DESCRIPTION OF THE DRAWINGS

FIG. 1 is a block diagram of a transmission system formed with a phase shifter according to an exemplary embodiment of the present invention.
FIG. 2 is a schematic view of a phase shifter according to an exemplary embodiment of the present invention.
FIG. 3 is a schematic view of a shape of a phase shifter printed on a PCB (Printed Circuit Board) according to an exemplary embodiment of the present invention.
FIG. 4 is a schematic view illustrating an operation of a phase shifter according to an exemplary embodiment of the present invention.
FIG. 5 is a schematic view illustrating a phase shifter that changes a phase by a size of 180 degrees according to an exemplary embodiment of the present invention.
FIG. 6 is a schematic view illustrating a phase shifter that changes a phase by a size of 90 degrees according to an exemplary embodiment of the present invention.
FIG. 7 are comparative views illustrating a case without a phase shifter according to exemplary embodiment of the present invention and a case with a phase shift according to exemplary embodiment of the present invention.

### BEST MODE

Various exemplary embodiments will be described more fully hereinafter with reference to the accompanying drawings, in which some exemplary embodiments are shown. The present inventive concept may, however, be embodied in many different forms and should not be construed as limited to the example embodiments set forth herein. Rather, the described aspect is intended to embrace all such alterations, modifications, and variations that fall within the scope and novel idea of the present disclosure.

Hereinafter, exemplary embodiments of the present invention will be described in detail with reference to the accompanying drawings.

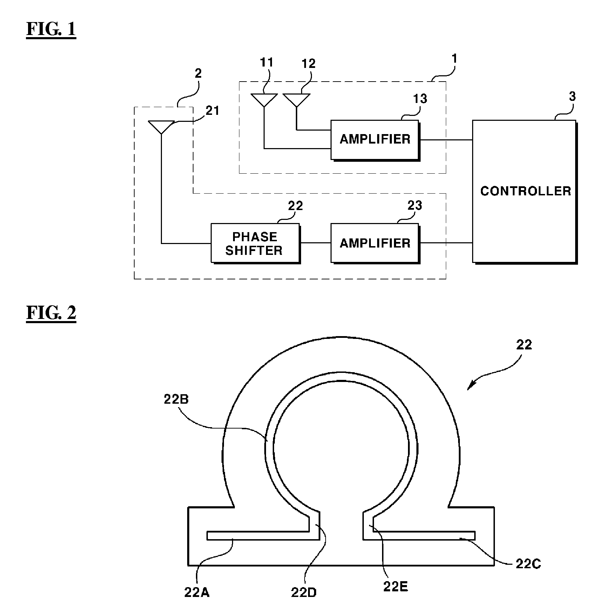

FIG. 1 is a block diagram of a transmission system formed with a phase shifter according to an exemplary embodiment of the present invention.

Referring to FIG. 1, a system according to an exemplary embodiment of the present invention may include a first transmission unit (1) configured to transmit a signal of first frequency band, a second transmission unit (2) configured to transmit a signal of second frequency band, and a controller (3) configured to transmit a signal to the first and second transmission units (1, 2).

The controller (3) may be embodied by an IC (Integrated Circuit) but detailed explanation thereto will be omitted here as it is irrelevant to the present invention.

The first transmission unit (1) may include first and second antennas (11, 12) and a first amplifier (13). Although the exemplary embodiment of the present invention has illustrated an example including two antennas, the present invention is not limited thereto and the first transmission unit (1) may include a configuration formed with a plurality of antennas.

A signal transmitted from the controller (3) may be amplified by the first amplifier (13) to be emitted through the first and second antennas (11, 12).

The second transmission unit (2) may include a third antenna (21), a phase shifter (22) and a second amplifier (23). Although the exemplary embodiment of the present invention has illustrated an example including two antennas, the present invention is not limited thereto and the second transmission unit (2) may include a configuration formed with a plurality of antennas. However, when the second transmission unit (2) includes a plurality of antennas, it should be apparent to the skilled in the art that each antenna is connected with a phase shifter (22).

A signal transmitted from the controller (3) may be amplified by the second amplifier (23) to be shifted in phase by the phase shifter (22) according to an exemplary embodiment of the present invention and to be emitted through the third antenna (21).

The phase shifter (22) according to an exemplary embodiment of the present invention may take one of Ω, 8, and ∝ shapes.

FIG. 2 is a schematic view of a phase shifter according to an exemplary embodiment of the present invention.

Referring to FIG. 2, the phase shifter (22) according to an exemplary embodiment of the present invention may include an input unit (22A) configured to input a signal, a phase shifter (22B) where a phase is shifted and outputted, and an output unit (22C) where a phase-shifted signal is outputted.

A signal inputted through the input unit (22A) may be shifted in phase by the phase shifter (22B) and outputted through the output unit (22C).

The phase shifter (22B) may have a predetermined size of diameter and take a partially opened round shape, and connected through the input unit (22A) and a first connector (22D), and connected through the output unit (22C) and a second connector (22E). The input unit (22A) and the output unit (22C) are illustrated to have a linear shape, but the present invention is not limited thereto, and the first connector (22D) and the second connector (22E) may be connected to an opened portion of the phase shifter (22B).

The shifted phase may be determined by size of the phase shifter (22B). That is, when the diameter of the phase shifter (22B) is of a first size, the phase may be shifted to 90 degrees, and when the diameter of the phase shifter (22B) is of a second size, the phase may be shifted to 120 degrees. Furthermore, when the diameter of the phase shifter (22B) is of a third size, the phase may be shifted to 180 degrees. At this time, the first size may be smaller than the second size and the second size may be smaller than the third size.

When the phase is shifted to 90 degrees, the number of antennas may be 3 to 4, when the phase is shifted to 120 degrees, the number of antennas may be 2 to 3, and when the phase is shifted to 180 degrees, the number of antennas may be 2.

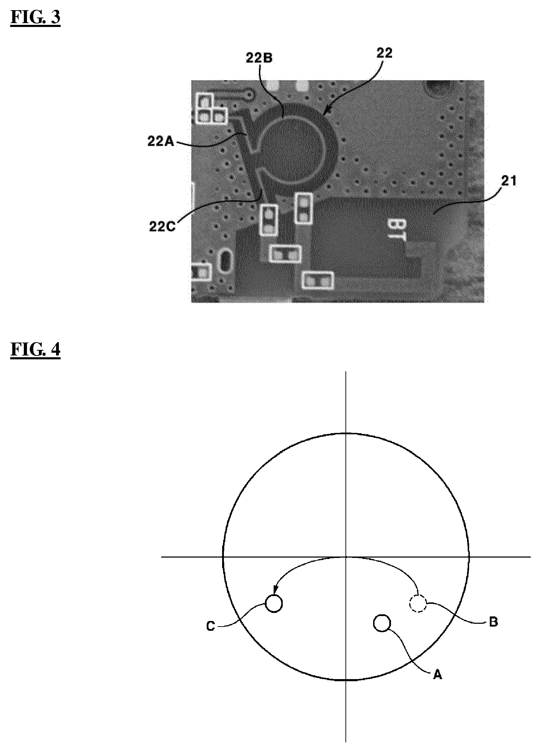

FIG. 3 is a schematic view of a shape of a phase shifter printed on a PCB according to an exemplary embodiment of the present invention.

Referring to FIG. 3, a signal inputted through the input unit (22A) of the phase shifter (22) through the second amplifier (23) may be phase-shifted by a predetermined angle by the phase shifter (22B), and a phase-shifted signal outputted through the output unit (22C) may be emitted through the third antenna (21).

Although the exemplary embodiment of the present invention in FIG. 3 has illustrated an example where the phase shifter is printed on a PCB, the present invention is not limited thereto, and the phase shifter may be variably configured in various transmission systems.

The signals outputted to the first and second transmission units (1, 2) may be signals of same frequency band, or of mutually different frequency bands.

When the signals outputted through the first and second transmission units (1, 2) are signals of same frequency band, a signal outputted through the first transmission unit (1) may be Wi-Fi signal, for example, and when the signal outputted through the second transmission unit (2) may be a Bluetooth® signal. However, it should be apparent to the skilled in the art that the present invention is not limited thereto.

FIG. 4 is a schematic view illustrating an operation of a phase shifter according to an exemplary embodiment of the present invention.

Referring to FIG. 4, when phases (A, B) of two signals are existent on a same phase plane, a phase (B) of one signal is orthogonally shifted to a phase (A) of another signal to allow phases of two signals to be mutually orthogonal, whereby data transmission speed can be enhanced.

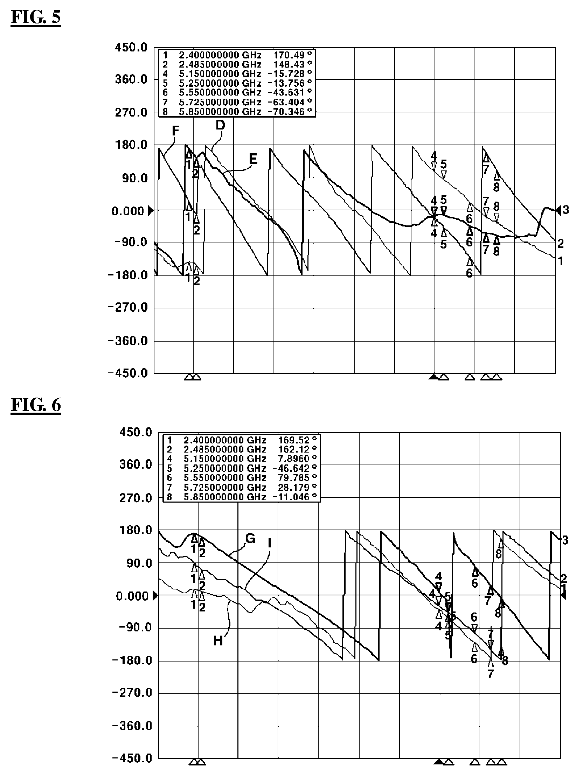

FIG. 5 is a schematic view illustrating a phase shifter that changes a phase by a size of 180 degrees according to an exemplary embodiment of the present invention, and FIG. 6 is a schematic view illustrating a phase shifter that changes a phase by a size of 90 degrees according to an exemplary embodiment of the present invention.

Referring to FIGS. 5 and 6, the first transmission unit (1) includes two antennas (11, 12) and the second transmission unit (2) includes one antenna (21).

D and E in FIG. 5 refer to signals transmitted through the first transmission unit (1), and F defines a signal transmitted through the second transmission unit (2). Furthermore, G and H in FIG. 6 define signals transmitted through the first transmission unit (1), and I refers to a signal transmitted through the second transmission unit (2).

As illustrated in the drawings, it can be noted that a signal inputted with the same phase is shifted to respectively 180 degrees and 90 degrees and transmitted through the first transmission unit (1) and a signal transmitted through the second transmission unit respectively have 180 degree and 90 degree phase differences.

It can be noted that a transmission system formed with a phase shifter according to an exemplary embodiment of the present invention can improve the transmission speed by more than 10Mbps when Wi-Fi and Bluetooth signals are simultaneously transmitted.

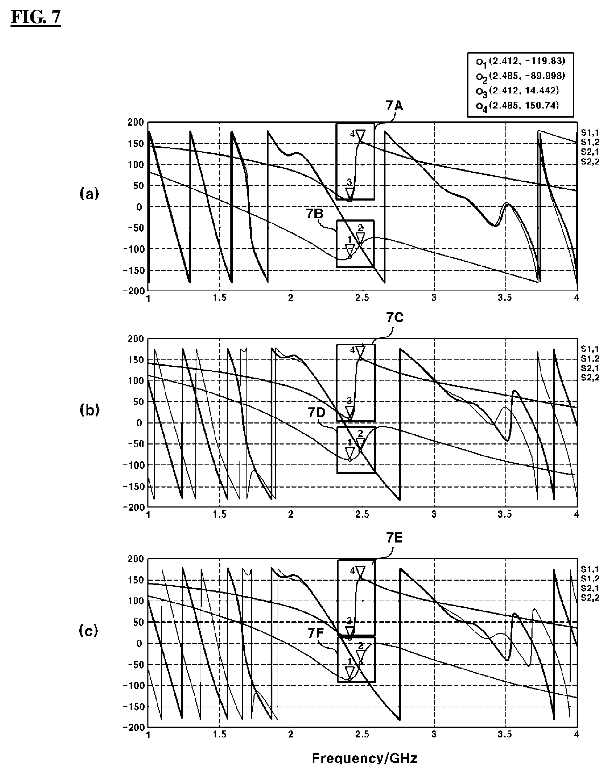

FIG. 7 are comparative views illustrating a case without a phase shifter according to exemplary embodiment of the present invention and a case with a phase shift according to exemplary embodiment of the present invention, where (a) of FIG.7A, (b) of FIG. 7C and (c) of FIG. 7E respectively illustrate phases of signal emitted through an antenna without a phase shifter, and (a) of FIG. 7B illustrates a case applied with a Ω type phase shifter, (b) of FIG. 7D illustrates a case applied with a 8 type phase shifter, and (c) of FIG. 7F illustrates a case applied with a ∝ type phase shifter.

As illustrated in the drawings, it can be noted that 7B, 7D and 7F are changed in phase over 7A, 7C and 7E, whereby a signal transmitted through each antenna comes to have a predetermined phase difference to improve a data transmission speed.

Although the phase shifter according to an exemplary embodiment of the present invention has been described with reference to a number of limited illustrative embodiments thereof, it should be understood that numerous other modifications and embodiments can be devised by those skilled in the art that will fall within the spirit and scope of the principles of this disclosure. Therefore, it should be understood that the above-described embodiments are not limited by any of the details of the foregoing description and drawings, unless otherwise specified, but rather should be construed broadly within the scope as defined in the appended claims.

## Claims

1. A phase shifter comprising:
an input unit through which a signal is inputted;
a phase shifter having a partially-opened round shape and configured to shift a phase of the signal; and
an output unit configured to output a phase-shifted signal by the phase shifter.

2. The phase shifter of claim 1, further comprising:
a first connector connected to a portion of a partially-opened part of the phase shifter and configured to connect the input unit and the phase shifter; and
a second connector connected to the other portion of the partially-opened part of the phase shifter and configured to connect the output unit and the phase shifter.

3. The phase shifter of claim 1, wherein the phase shifted by the phase shifter is determined by size of a diameter of the phase shifter.

4. A transmission system using a phase shifter, the system comprising:
a first transmission unit configured to transmit a first signal through at least one first antenna; and
a second transmission unit configured to transmit a second signal through at least one second antenna,
wherein the second transmission unit includes a phase shifter configured to shift the second signal to have a phase difference from the first signal.

5. The transmission system of claim 4, wherein the number of the phase shifter corresponds to that of the at least second antenna.

6. The transmission system of claim 5, wherein the phase shifter has one of Ω, 8, and ∝ shapes.

7. The transmission system of claim 5, wherein a frequency band of the first signal corresponds to that of the second signal.

8. The transmission system of claim 5, wherein a frequency band of the first signal is different from that of the second signal.
